Europäisches Patentamt

European Patent Office

Office européen des brevets

(11) Numéro de publication: **0 348 283**
**A1**

## (12) DEMANDE DE BREVET EUROPEEN

(21) Numéro de dépôt: **89401705.2**

(22) Date de dépôt: **16.06.89**

(51) Int. Cl.⁴: **H 03 B 19/00**

(30) Priorité: **24.06.88 FR 8808528**

(43) Date de publication de la demande:
**27.12.89 Bulletin 89/52**

(84) Etats contractants désignés: **DE GB IT NL**

(71) Demandeur: **THOMSON-CSF**
**51, Esplanade du Général de Gaulle**
**F-92800 Puteaux (FR)**

(72) Inventeur: **Quievy, Didier**
**THOMSON-CSF SCPI Cédex 67**
**F-92045 Paris la Défense (FR)**

**Desjouis, Francis**
**THOMSON-CSF SCPI Cédex 67**
**F-92045 Paris la Défense (FR)**

(74) Mandataire: **Benoit, Monique et al**
**THOMSON-CSF SCPI**
**F-92045 PARIS LA DEFENSE CEDEX 67 (FR)**

(54) Multiplicateur de fréquence à rang de multiplication programmable.

(57) Ce circuit multiplicateur de fréquence à rang de multiplication variable est du type comportant un générateur de peigne
(1) recevant en entrée un signal à la fréquence de base ($f_e$) à
multiplier et délivrant en sortie un signal impulsionnel composite (A) comportant une pluralité de raies harmoniques de la
fréquence de base, ce générateur de peigne étant suivi par un
filtre passe-bande (2) accordable sélectivement sur l'une ($N.f_e$)
de ces raies harmoniques.
Selon l'invention, le générateur de peigne (1) est formé par des
moyens logiques présentant deux sorties complémentées
(Q,Q/), une entrée synchrone (H) dont l'activation commande le
passage de ces sorties d'un état logique à l'autre, et une entrée
asynchrone (R) dont l'activation commande, indépendamment
de l'état de l'entrée asychrone, le passage de ces sorties aux
états complémentaires de ceux qui sont générés par activation
de l'entrée synchrone ; le signal à la fréquence de base est
préalablement polarisé de manière que son excursion ait lieu
autour de la tension de transition commandant le passage d'un
état logique à l'autre, ce signal étant appliqué à l'entrée
synchrone des moyens logiques ; et une première sortie (Q) de
ces moyens est reliée à l'entrée asynchrone (R) et la seconde
sortie (Q/) délivre au filtre passe-bande situé en aval ledit signal
impulsionnel composite.

FIG_2

EP 0 348 283 A1

Description

## Multiplicateur de fréquence à rang de multiplication programmable

La présente invention concerne un circuit multiplicateur de fréquence à rang de multiplication variable.

L'invention s'applique en particulier, mais de façon non limitative, à la génération de signaux par synthèse de fréquence, technique couramment utilisée dans les radars et les systèmes de télécommunication.

En effet, la multiplication de fréquence figure parmi les opérations fondamentales de la synthèse de fréquence, et on peut employer avantageusement à cet effet un multiplicateur de fréquence dont le rang de multiplication est variable soit par une commande mécanique ou analogique, soit par une commande numérique (on parle alors de rang de multiplication programmable).

On connaît de nombreux circuits de multiplication de fréquence, qui sont fondés sur la production d'énergie distribuée sur des harmoniques d'une fréquence de base appliquée en entrée au multiplicateur.

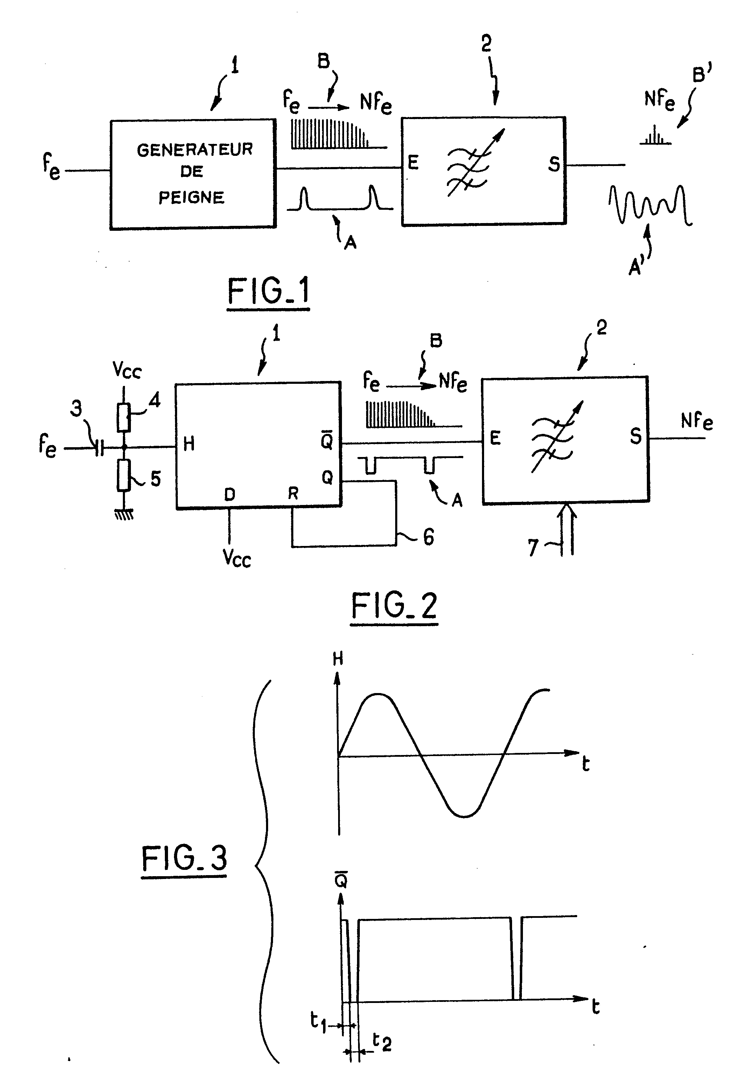

Lorsque l'on recherche une multiplication à rang élevé (c'est à dire supérieure à cinq) et/ou variable ou programmable, on utilise généralement un circuit du type illustré figure 1, comprenant essentiellement un générateur de peigne 1 associé à un filtre passe-bande accordable 2.

Le signal à la fréquence de base $f_e$ appliqué en entrée du générateur de peigne est déformé par la caractéristique de transfert non-linéaire de celui-ci en une onde temporelle ayant la forme représentée en A, et dont l'image fréquentielle, représentée en B, est un spectre en peigne comportant un nombre important d'harmoniques de la fréquence de base $f_e$.

Ce signal A,B est appliqué à un filtre passe-bande accordable 2 qui ne sélectionne que la raie harmonique de rang N (illustrée en B'), c'est à dire correspondant à la fréquence $N.f_e$, et elle seule (si l'on fait abstraction des raies parasites environnantes qui tiennent au fait que la réponse du filtre ne présente jamais des flancs parfaitement abrupts) ; l'onde temporelle correspondante est représentée en A'.

Pour le générateur de peigne 1, on a jusqu'à présent utilisé une diode de type « snap-off » (diode à recouvrement abrupt), composant qui est bien connu pour ses applications hyperfréquences, la réaction de commutation très brutale du sens direct en sens inverse permettant la génération d'harmoniques de rang élevé avec un niveau énergétique relativement constant sur une large plage de fréquences harmoniques.

Néanmoins, ce montage présente certains inconvénients, inhérents aux propriétés des diodes snap-off, notamment le faible rendement, le bruit de phase intrinsèque élevé et la sensibilité à la charge et à l'environnement.

Pour limiter ces inconvénients, il est nécessaire de prévoir une puissance d'attaque élevée en entrée du générateur de peigne, ainsi qu'un étage d'isolation entre le générateur de peigne 1 et le filtre passe-bande 2 pour éviter que les caractéristiques d'impédance de celui-ci ne viennent perturber le fonctionnement du générateur de peigne.

L'un des buts de la présente invention est de proposer un circuit qui remédie à ces inconvénients, et permette de constituer un multiplicateur de fréquence simple à concevoir et économique à réaliser, fonctionnant avec un excellent rendement (en faisant ainsi l'économie d'un étage d'attaque en entrée du générateur de peigne), permettant un couplage direct entre le générateur de peigne et le filtre sélectif, et capable de délivrer en sortie un signal de fréquence multipliée étroitement corrélé au signal d'entrée à la fréquence de base, avec notamment un bruit de phase intrinsèque très faible.

L'invention a également pour objet la réalisation d'un tel circuit fonctionnant dans une très large gamme de fréquences, typiquement entre 100 kHz et 1 GHz, en conservant une amplitude des raies harmoniques pratiquement constante sur toute la plage de fréquences utilisée ( « bande agile » ).

Un autre but de la présente invention est de rendre ce mutiplicateur de fréquence programmable, c'est-à-dire de permettre que le rang de multiplication soit choisi par une commande de type logique, par exemple un mot numérique appliqué au circuit.

A cet effet, l'invention propose un circuit multiplicateur de fréquence du type général indiqué plus haut, c'est-à-dire comportant un générateur de peigne recevant en entrée un signal à la fréquence de base à multiplier et délivrant en sortie un signal impulsionnel composite comportant une pluralité de raies harmoniques de la fréquence de base, ce générateur de peigne étant suivi par un filtre passe-bande accordable sélectivement sur l'une de ces raies harmoniques.

Selon l'invention : le générateur de peigne est formé par des moyens logiques présentant deux sorties complémentées, une entrée synchrone dont l'activation commande le passage de ces sorties d'un état logique à l'autre, et une entrée asynchrone dont l'activation commande, indépendamment de l'état de l'entrée synchrone, le passage de ces sorties aux états complémentaires de ceux qui sont générés par activation de l'entrée synchrone ; le signal à la fréquence de base est préalablement polarisé de manière que son excursion ait lieu autour de la tension de transition commandant le passage d'un état logique à l'autre, ce signal étant appliqué à l'entrée synchrone des moyens logiques ; et une première sortie de ces moyens est reliée à l'entrée asynchrone et la seconde sortie délivre au filtre passe-bande situé en aval ledit signal impulsionnel composite.

Selon un certain nombre de caractéristiques avantageuses de l'invention :

- l'entrée asynchrone est reliée à ladite première sortie des moyens logiques avec interposition d'un élément à constante de temps, de manière à allonger à l'optimum la durée du signal impulsionnel composite délivrée sur ladite seconde sortie des moyens logiques ;

lesdits moyens logiques sont des moyens à bascule, l'entrée synchrone étant constituée par l'entrée d'horloge et l'entrée asynchrone étant constituée par l'entrée de remise à zéro ; ces moyens à bascule peuvent notamment comprendre une bascule de type D dont l'entrée D est portée au niveau logique haut ;

le filtre passe-bande est un filtre à commande numérique, de manière à rendre programmable le rang de multiplication du circuit ; et

- il est prévu, en sortie du filtre passe-bande, un limiteur d'amplitude permettant de ne conserver essentiellement, du signal en sortie du filtre passe-bande, que la modulation de phase de ce signal, en réduisant à un minimum sa modulation d'amplitude.

D'autres caractéristiques et avantages de l'invention apparaîtront à la lecture de la description détaillée ci-dessous de diverses formes de réalisation, en référence aux dessins annexés sur lesquels ;

- la figure 1, précitée, montre la structure générale, en elle-même connue, d'un circuit multiplicateur de fréquence fonctionnant à partir d'un générateur de peigne,

- la figure 2 est homologue de la figure 1, pour le circuit de la présente invention,

- la figure 3 montre les chronogrammes respectifs des signaux en entrée et en sortie du générateur de peigne du circuit de la figure 2,

- la figure 4 montre un exemple de filtre passe-bande programmable utilisable dans le circuit de la figure 2,

- la figure 5 montre un autre exemple de filtre passe-bande programmable utilisable dans le circuit de la figure 2,

- la figure 6 est une variante du circuit de la figure 2, comportant un certain nombre de modifications avantageuses.

La figure 2 montre le schéma général de principe du circuit de la présente invention, dans lequel, comme sur la figure 1, un générateur de peigne 1 produit des signaux appliqués à un filtre passe-bande ajustable 2.

De façon caractéristique de la présente invention, le générateur de peigne 1, au lieu d'être constitué d'un composant analogique présentant une caractéristique de transfert non linéaire (typiquement, une diode snap-off) comme dans l'art antérieur, est constitué d'un circuit logique à bascule dont le basculement brutal, provoqué, permet de générer des harmoniques de rang élevé.

On peut notamment utiliser à cet effet, comme illustré sur le figure 2, une bascule de type D dont l'entrée d'horloge H (entrée commandant le basculement) reçoit le signal à la fréquence de base $f_e$ via un condensateur de découplage 3. Ce signal est polarisé, par l'intermédiaire d'un pont diviseur à résistances 4 et 5, à une tension voisine de la tension de transition de la bascule, de manière que l'excursion de ce signal se fasse autour de cette tension de transition. La forme d'onde du signal à la fréquence de base fe n'est pas critique (sauf en ce qui concerne le bruit de phase, qui s'avère meilleur pour un signal carré), ce signal pouvant être aussi bien sinusoïdal, comme représenté sur le chronogramme du haut de la figure 3, que carré, triangulaire,...

L'entrée D de la bascule est portée au niveau haut, de manière que le basculement ne soit contrôlé que par un seul ordre logique, à savoir le signal appliqué à l'entrée d'horloge H.

La sortie complémentée Q/ constitue la sortie du générateur de peigne, tandis que la sortie non complémentée Q est bouclée sur l'entrée R de remise à zéro par une liaison directe 6.

On va maintenant décrire le fonctionnement de ce générateur de peigne, à savoir la manière dont, en recevant à son entrée le signal $f_e$, la bascule va générer sur la sortie Q/ l'impulsion fine, représentée sur le chronogramme du bas de la figure 3.

La transition active du signal sur l'entrée d'horloge à la fréquence $f_e$ fait basculer - de façon synchrone - la sortie Q au même état logique que celui présent sur l'entrée D, c'est-à-dire à l'état logique haut puisque cette entrée est reliée en permanence à la tension continue d'alimentation, au bout d'un temps $t_1$ correspondant au temps de retard intrinsèque de la bascule.

Le niveau haut ainsi obtenu sur la sortie Q va activer - de façon asynchrone - l'entrée de remise à zéro R, forçant ainsi la sortie Q à l'état complémentaire de celui de l'entrée D, donc à l'état bas, au bout d'un temps $t_2$ lié au temps de réponse des circuits utilisés pour la bascule.

Le signal Q/, complémentaire du signal Q, présentera donc l'aspect indiqué sur le chronogramme du bas de la figurè 3, une impulsion donc étant générée pendant la durée $t_2$ précitée.

Cette impulsion est générée à la même fréquence $f_e$ que le signal de base appliqué à l'entrée H mais présente, du fait de son aspect impulsionnel, un spectre harmonique très riche, avec une amplitude des raies successives dont l'enveloppe est sensiblement en sin x/x, c'est-à-dire comparable à ce qui serait obtenu avec un générateur de peigne du type à diode snap-off, si bien qu'il est possible d'obtenir un niveau énergétique relativement constant sur une large plage de raies harmoniques.

Cependant, à la différence du montage à diode snap-off, on constate que le bruit de phase du spectre résultant est très faible et qu'en outre le rendement énergétique du générateur de peigne à bascule est très élevé, de sorte qu'il n'est pas besoin de prévoir, comme dans l'art antérieur, de circuit d'attaque en amont du générateur de peigne, circuit qui constituait lui-même une source supplémentaire de bruits de phase parasites.

En outre, du fait que le générateur de peigne est un circuit logique, le signal à la sortie Q/ est totalement indépendant de la charge présente à cette borne du circuit logique, de sorte que l'on pourra relier directement la sortie Q/ de la bascule à l'entrée E du filtre, sans l'étage d'isolation qui était nécessaire dans l'art antérieur, étage qui, outre son coût et la complexité de conception qu'il implique, constituait une source supplémentaire de dégradation de la qualité du signal délivré par le générateur de peigne.

La durée $t_2$ pendant laquelle est produite l'impulsion est liée à la rapidité du circuit logique et dépend donc de la technologie utilisée. En pratique, le peigne de raies harmoniques associé à ces impulsions est exploitable pratiquement jusqu'à une fréquence maximale $f_{max} = 0,5/t_2$ pour une bande à -3 dB.

Ainsi, avec les techniques couramment utilisées, on peut obtenir des raies harmoniques jusqu'à des fréquences de 100 à 200 MHz avec des logiques rapides TTL et CMOS rapides ($t_2$ de l'ordre de 2,5 à 5 ns), 160 à 330 MHz en logique ECL ($t_2$ de l'ordre de 1,5 ns), et jusqu'à 1 GHz avec des circuits logiques AsGa ($t_2$ de l'ordre de 500 ps).

En ce qui concerne la limite inférieure, le temps de montée du signal appliqué à l'entrée H ne peut être inférieur à une valeur limite imposée par la technologie employée ; si l'on souhaite descendre en deçà de ce seuil il suffit, au lieu d'appliquer directement le signal à la fréquence $f_e$ à l'entrée de la bascule, de placer en amont de celle-ci un circuit de mise en forme du type déclencheur de Schmitt, de sorte que la fréquence de base $f_e$ en entrée n'aura aucune limite inférieure.

On peut utiliser pour le circuit logique d'autres configurations qu'une bascule D, la plupart des circuits logiques de type séquentiel étant utilisables pour réaliser la fonction que l'on vient de décrire, notamment les bascules flip-flop, les registres à décalage, les compteurs, etc.

De façon générale, le circuit logique doit présenter :
- deux sorties complémentées Q et Q/,
- une entrée synchrone (l'entrée d'horloge H dans l'exemple de réalisation de la figure 2), dont l'activation commande le passage de ces sorties d'un état logique à l'autre (par transmission de l'état fixé sur l'entrée D à la sortie Q et de ce même état inversé à la sortie Q/, dans l'exemple de réalisation de la figure 2), et
- une entrée asynchrone ((l'entrée de remise à zéro R dans l'exemple de réalisation de la figure 2), dont l'activation commande, indépendamment de l'état de l'entrée asynchrone, le passage des sorties Q et Q/ aux états complémentaires de ceux qui sont générés par activation de l'entrée synchrone (par forçage à zéro, dans l'exemple de réalisation de la figure 2).

Plus précisément, l'entrée asynchrone peut permettre soit le forçage à zéro, soit le forçage à un de l'état logique de la sortie Q, et l'activation de cette entrée peut être réalisée soit par un état "0" (exemple d'une logique TTL ou CMOS) soit par un état "1" (exemple d'une logique ECL) : on peut déduire ainsi quatre schémas de base possibles, tous fonctionnellement équivalents.

En ce qui concerne le filtre passe-bande 2, on peut utiliser de nombreux montages classiques, le type de filtre utilisé n'étant pas critique pour le fonctionnement du générateur de peigne puisque celui-ci, de type logique, fonctionnera de manière invariable quelle que soit la charge couplée à sa sortie.

Avantageusement, on utilise un filtre de type programmable, c'est-à-dire dont la fréquence centrale (et donc le rang de multiplication choisi) est déterminé par application d'une commande numérique sur un bus de commande 7.

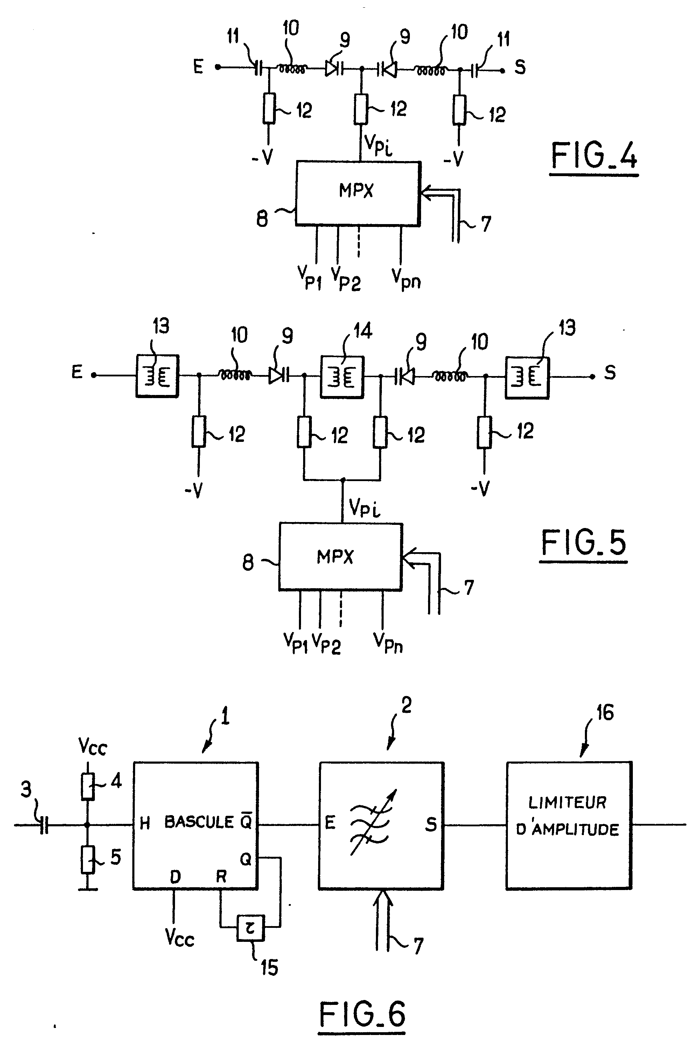

La figure 4 décrit un tel type de filtre : celui-ci, qui est un filtre monopolaire symétrique, comporte essentiellement deux circuits de type LC série en opposition constitués chacun par un varactor 9 en série avec une inductance 10, la fréquence d'accord du filtre étant modifiée en faisant varier la polarisation appliquée à la cathode du varactor. Cette polarisation variable peut notamment être réalisée au moyen d'un multiplexeur analogique 8 sélectionnant, en fonction du signal de commande 7 qui lui est appliqué, une tension $V_{Pi}$ parmi une pluralité de tension $V_{P1}, V_{P2}... V_{Pn}$, chacune de ces tensions correspondant à une valeur du varactor 9 assurant un accord du circuit résonnant LC 9,10 sur une fréquence centrée sur l'une des raies du peigne de fréquences appliqué à l'entrée E.

Ce filtre comporte également des condensateurs de liaison 11 en entrée et en sortie, ainsi que des impédances 12 formées d'inductances d'arrêt et/ou de résistances de forte valeur permettant d'isoler les signaux haute fréquence des tensions continues appliquées aux cathodes et aux anodes des varactors.

Un tel filtre à varactors présente à la fois une sélectivité de filtrage élevée (pour permettre d'isoler la raie harmonique utile du spectre, et elle seule) et la couverture d'une large bande de fréquences, c'est-à-dire la possibilité d'être accordé sur un nombre élevé de rangs de multiplication, typiquement jusqu'à la vingtième harmonique.

La figure 5 représente une variante perfectionnée du filtre de la figure 4, où l'on a modifié le filtre de la figure 4 par adjonction de transformateurs adaptateurs d'impédance 13,14,15 de manière à obtenir une structure de filtre à deux pôles de type pseudo-symétrique, c'est-à-dire que les impédances présentes sur les bornes E et S peuvent, si besoin est, être choisies différentes (grâce à l'adjonction des transformateurs 13,14,15).

Des filtres tels que ceux des figures 4 et 5 permettent, avec toute la sélectivité voulue, d'obtenir un fonctionnement satisfaisant sur une bande agile d'une octave environ ; pour des bandes agiles plus larges, il suffit de prévoir une pluralité de filtres de sous-bandes contiguës, mis en oeuvre sélectivement par un multiplexage approprié.

En ce qui concerne les performances de ce circuit, on a pu mesurer un bruit de phase intrinsèque amélioré d'au moins 10 dB par rapport au multiplicateur de l'art antérieur à diode snap-off, grâce à l'utilisation de circuits en technologie CMOS, qui sont actuellement les plus performants dans ce domaine.

On a illustré sur la figure 6 une variante du schéma de la figure 2, dans laquelle deux améliorations (indépendantes l'une de l'autre) ont été apportées.

En premier lieu, en ce qui concerne le générateur de peigne, la sortie Q n'est plus reliée directement à l'entrée de remise à zéro R, mais par l'intermédiaire d'un réseau à constante de temps 15, par exemple un réseau passe-bas RC, la résistance étant montée entre les bornes Q et R de la bascule, et le condensateur étant monté entre la borne R et la masse.

L'incorporation de ce réseau 15 permet d'augmenter la durée de l'impulsion (durée $t_2$ du chronogramme de la figure 3), ce qui permet d'optimiser le rendement énergétique en fonction de la plage de fréquences de sortie à couvrir.

En second lieu, on peut prévoir en sortie du filtre 2 un limiteur d'amplitude 16 qui permettra de diminuer le niveau relatif des raies parasites par rapport à la raie utile, sans pour autant modifier la structure du filtre.

Ce limiteur 16 peut notamment être un limiteur d'amplitude réalisant un écrêtage symétrique du signal modulé en amplitude et en phase délivré en sortie du filtre 2, signal qui ne présente quant à lui aucun transfert de modulation d'amplitude ni de phase. De la sorte, seule subsiste en sortie du limiteur l'énergie de modulation de phase, ce qui permettra de diminuer les raies parasites sur le signal obtenu en sortie du circuit.

Ce circuit limiteur peut notamment être constitué d'un étage différentiel à transistors de type classique, qui convient parfaitement à la mise en oeuvre de la présente invention. Cet étage est précédé si nécessaire d'un amplificateur linéaire.

Typiquement, on peut obtenir, pour un niveau maximum de modulation parasite de -6 dBc en sortie du filtre 2, un niveau maximum de modulation parasite de -30 dBc en sortie du limiteur 16.

## Revendications

1. Un circuit multiplicateur de fréquence à rang de multiplication variable, comportant un générateur de peigne (1) recevant en entrée un signal à la fréquence de base ($f_e$) à multiplier et délivrant en sortie un signal impulsionnel composite (A) comportant une pluralité de raies harmoniques de la fréquence de base, ce générateur de peigne étant suivi par un filtre passe-bande (2) accordable sélectivement sur l'une ($N.f_e$) de ces raies harmoniques, caractérisé en ce que le générateur de peigne (1) est formé par des moyens logiques présentant deux sorties complémentées, une entrée synchrone dont l'activation commande le passage de ces sorties d'un état logique à l'autre, et une entrée asynchrone dont l'activation commande, indépendamment de l'état de l'entrée synchrone, le passage de ces sorties aux états complémentaires de ceux qui sont générés par activation de l'entrée synchrone, en ce que le signal à la fréquence de base est préalablement polarisé de manière que son excursion ait lieu autour de la tension de transition commandant le passage d'un état logique à l'autre, ce signal étant appliqué à l'entrée synchrone des moyens logiques, et en ce qu'une première sortie de ces moyens est reliée à l'entrée asynchrone et la seconde sortie délivre au filtre passe-bande situé en aval ledit signal impulsionnel composite.

2. Le circuit de la revendication 1, dans lequel l'entrée asynchrone est reliée à ladite première sortie des moyens logiques avec interposition d'un élément (15) à constante de temps, de manière à allonger à l'optimum la durée du signal impulsionnel composite délivrée sur ladite seconde sortie des moyens logiques.

3. Le circuit de la revendication 1, dans lequel lesdits moyens logiques sont des moyens à bascule, l'entrée synchrone étant constituée par l'entrée d'horloge (H) et l'entrée asynchrone étant constituée par l'entrée de remise à zéro (R).

4. Le circuit de l'une des revendications 1 ou 2, dans lequel les moyens à bascule comprennent une bascule de type D dont l'entrée D est portée au niveau logique haut.

5. Le circuit de l'une des revendications 1 à 4, dans lequel le filtre passe-bande (2) est un filtre à commande numérique, de manière à rendre programmable le rang de multiplication du circuit.

6. Le circuit de l'une des revendications 1 à 5, dans lequel il est prévu, en sortie du filtre passe-bande (2), un limiteur d'amplitude (16) permettant de ne conserver essentiellement, du signal en sortie du filtre passe-bande, que la modulation de phase de ce signal, en réduisant à un minimum sa modulation d'amplitude.

$$\underline{FIG\_1}$$

$$\underline{FIG\_2}$$

$$\underline{FIG\_3}$$

_FIG.4_

_FIG.5_

_FIG.6_

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-3 777 271 (TELEWSKI) <br> * Figure 3; colonne 3, ligne 47 - colonne 4, ligne 12 * <br> --- | 1-4 | H 03 B 19/00 |
| A | US-A-4 137 503 (ZIESMER) <br> * Figure 1A; colonne 2, ligne 49 - colonne 3, ligne 14 * <br> --- | 1-4 | |
| A | EP-A-0 138 438 (SALORA OY) <br> * Figure 3; page 4, lignes 10-15 * <br> --- | 1-6 | |
| T | IEEE TRANSACTIONS ON ELECTRON DEVICES, vol. ED-16, no. 2, février 1969, pages 225-227, New York, US; G.F. ROSS: "Synchronized microwave energy generation by harmonic filtering" <br> * En entier * <br> ----- | | |

|  |
|---|
| **DOMAINES TECHNIQUES RECHERCHES (Int. Cl.4)** |
| H 03 B <br> H 03 H <br> H 03 K <br> H 03 G |

Le présent rapport a été établi pour toutes les revendications

| Lieu de la recherche | Date d'achèvement de la recherche | Examinateur |
|---|---|---|
| LA HAYE | 05-10-1989 | PEETERS M.M.G. |

EPO FORM 1503 03.82 (P0402)